(19) Europäisches Patentamt / European Patent Office / Office européen des brevets

(11) **EP 3 895 313 B1**

(12) **EUROPÄISCHE PATENTSCHRIFT**

(45) Veröffentlichungstag und Bekanntmachung des Hinweises auf die Patenterteilung:
**18.12.2024   Patentblatt 2024/51**

(21) Anmeldenummer: **19829159.3**

(22) Anmeldetag: **19.12.2019**

(51) Internationale Patentklassifikation (IPC):
**H03K 17/16** (2006.01)       **H03K 17/10** (2006.01)

(52) Gemeinsame Patentklassifikation (CPC):
**H03K 17/166; H03K 17/102**

(86) Internationale Anmeldenummer:
**PCT/EP2019/086185**

(87) Internationale Veröffentlichungsnummer:
**WO 2020/160830 (13.08.2020 Gazette 2020/33)**

(54) **SCHALTVORRICHTUNG ZUM AUFTRENNEN EINES STROMPFADS**

SWITCHING DEVICE FOR SEPARATING A CURRENT PATH

DISPOSITIF DE COMMUTATION DESTINÉ À SÉPARER UN CHEMIN DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **05.02.2019  EP 19155486**

(43) Veröffentlichungstag der Anmeldung:
**20.10.2021   Patentblatt 2021/42**

(73) Patentinhaber: **Siemens Aktiengesellschaft**
**80333 München (DE)**

(72) Erfinder:
• **HÄNSEL, Stefan**
  **91056 Erlangen (DE)**
• **HANDT, Karsten**
  **92348 Berg (DE)**

(74) Vertreter: **Siemens Patent Attorneys**
**Postfach 22 16 34**
**80506 München (DE)**

(56) Entgegenhaltungen:
EP-A1- 3 367 567       DE-A1- 102006 009 127
US-A1- 2005 276 020

**Beschreibung**

Die Erfindung betrifft eine Schaltvorrichtung zum Auftrennen eines quell- und lastseitige Induktivitäten umfassenden Strompfads eines Gleichspannungsnetzes.

Eine Schaltvorrichtung, die zum Auftrennen eines Gleichstrompfads mit quell- und lastseitigen Induktivitäten vorgesehen ist, muss die Rückspeisung oder den Abbau von Energie aus dem Gleichspannungsnetz handhaben können. Beim schnellen Abschalten bauen sich hohe Spannungen auf, die über eine Schutzbeschaltung abgebaut werden müssen, um Schäden an den Komponenten der Schaltvorrichtung zu verhindern.

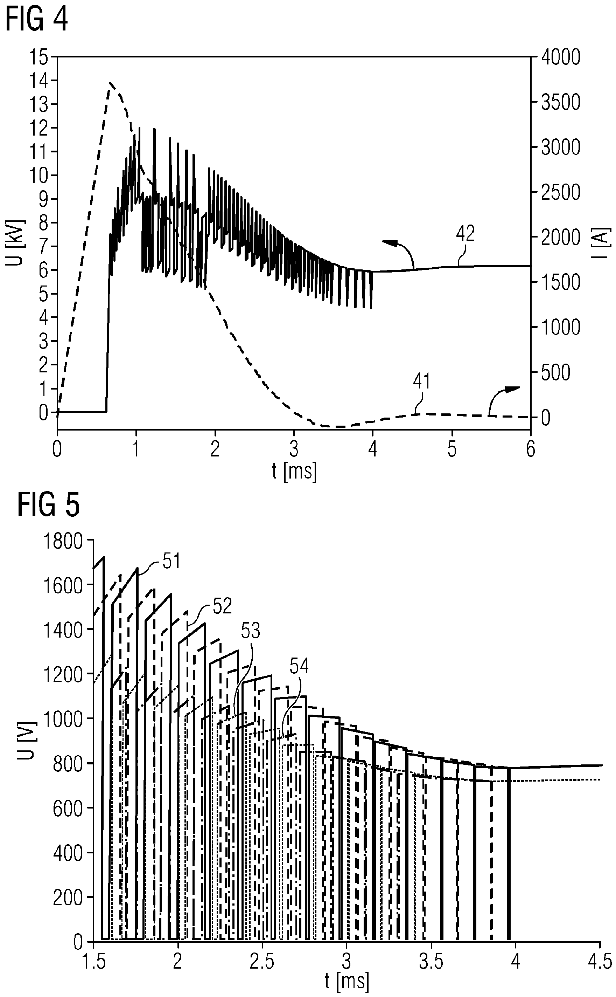

Aus der EP 3 367 567 A1 ist eine Schaltvorrichtung gemäß dem Oberbegriff von Anspruch 1 bekannt. Nachteilig an dieser Schaltung ist ein pendelnder Stromfluss, also eine Schwingung, nach einem Abschaltvorgang, wie in der dortigen Figur 4 erkennbar. Diese Schwingung hat Zeitkonstanten im Bereich von 10-50 Millisekunden, hält also vergleichsweise lange an.

Es ist Aufgabe der Erfindung, eine verbesserte Schaltvorrichtung zum Auftrennen eines quell- und lastseitige Induktivitäten umfassenden Strompfads eines Gleichspannungsnetzes anzugeben, die baulich und/oder funktionell verbessert ist. Insbesondere soll die Schaltvorrichtung Pendelströme nach einem Abschaltvorgang vermeiden.

Diese Aufgabe wird gelöst durch eine Schaltvorrichtung mit den Merkmalen von Patentanspruch 1. Vorteilhafte Ausgestaltungen ergeben sich aus den abhängigen Ansprüchen.

Die erfindungsgemäße Schaltvorrichtung zum Auftrennen eines quell- und lastseitige Induktivitäten umfassenden Strompfads eines Gleichspannungsnetzes umfasst wenigstens zwei in Serie verschaltete Schaltmodule. Jedes der Schaltmodule umfasst zumindest ein steuerbares Halbleiterschaltelement, dem eine Serienschaltung aus einem Widerstand und einem Kondensator parallelgeschaltet ist. Die Schaltvorrichtung ist so ausgebildet, dass Zum Auftrennen des Strompfads zum Abbau der in den Induktivitäten gespeicherten Energie das steuerbare Halbleiterschaltelement wenigstens eines der Schaltmodule mit einem Tastgrad leitend geschaltet wird. Dabei wird der Tastgrad unter Verwendung der Differenz zwischen der Istspannung über das Halbleiterschaltelement und einer Sollspannung über das Halbleiterschaltelement gebildet und die Sollspannung wenigstens aus der Systemspannung des Gleichspannungsnetzes und der Anzahl der Schaltmodule gebildet.

Eine derartige Schaltvorrichtung ermöglicht einen "weichen" Abschaltvorgang, bei dem der Stromfluss in dem Strompfad nicht abrupt, sondern rampenförmig abgebaut wird. Durch wenigstens eines der zumindest zwei Schaltmodule wird eine Gegenspannung im Strompfad aufgebaut. Dies wird durch einen Betrieb des jeweiligen Halbleiterschalterelements der Schaltmodule mit einem Tastgrad ermöglicht. Damit wird die hohe Verlustleistung im Abschaltfall nicht in dem Halbleiterschaltelement der jeweiligen Schaltmodule umgesetzt, sondern überwiegend in dem Widerstand der jeweiligen Schaltmodule. Die Schaltvorrichtung kann dadurch auf spannungsbegrenzende Bauelemente, wie Varistoren, verzichten, die teuer, schwer und bauraumintensiv sind. Das Halbleiterschaltelement in den jeweiligen Schaltmodulen übernimmt dabei die Rolle des Bremschoppers. Gleichzeitig kann der jeweilige Kondensator der Schaltmodule klein dimensioniert werden, da er nicht die gesamte, in den quell- und lastseitigen Induktivitäten gespeicherte Energie aufnehmen muss, sondern lediglich einen kleinen Teil aufgrund des getakteten Betriebs des Halbleiterschaltelements der betreffenden Schaltmodule. Die abzubauende Gesamtenergie ist damit nicht durch das Halbleiterschaltelement der betreffenden Schaltmodule begrenzt. Lediglich dauert der Abschaltvorgang bei größeren quell- und lastseitigen Induktivitäten länger.

Betrieb mit einem Tastgrad bezeichnet dabei einen Wechsel zwischen eingeschaltetem und abgeschaltetem Zustand des Halbleiterschalterelements mit einer vorgegebenen Frequenz, also Periodendauer. Innerhalb einer Periode wird das Halbleiterschalterelement einmal eingeschaltet, also leitend geschaltet, und einmal abgeschaltet, also sperrend geschaltet. Der Tastgrad gibt den Anteil an der Periodendauer an, zu dem das Halbleiterschalterelement eingeschaltet ist. Während der Zeit, in der das steuerbare Halbleiterschaltelement des betreffenden Schaltmoduls sperrend geschaltet ist, kann der Strom in diesem Schaltmodul nur noch über den parallelen Pfad des RC-Glieds weiterfließen. Der Kondensator des RC-Glieds lädt sich dadurch auf.

Besonders vorteilhaft an dem Betrieb mit einem Tastgrad, der von der Differenz zwischen der Istspannung und der Sollspannung abhängt, ist eine Verlangsamung des Energieabbaus zum Ende eines Abschaltvorgangs hin. Dadurch wird ein möglichst schnelles Erreichen eines Nulldurchgangs des Stroms vermieden. Dadurch werden Schwingungen nach dem Abschaltvorgang fast völlig unterbunden. Bei anderen Verfahren ist beim ersten Stromnulldurchgang die gesamte Kondensatorspannung über die Schaltvorrichtung bedingt durch die quell- und lastseitigen Induktivitäten höher als die Systemspannung des Gleichspannungsnetzwerks. Dadurch folgen auf den Stromnulldurchgang ein Stromrückfluss und ein nachfolgender Schwingungsvorgang dessen Dauer zehnmal der Dauer des Abschaltvorgangs entsprechen kann. Durch den Betrieb mit einem Tastgrad verzögert sich der Abschaltvorgang hingegen nur um beispielsweise 25%.

Ein vorteilhafter Einsatz der Schaltvorrichtung ist insbesondere in Schiffen möglich, dort insbesondere in Mittelspannungs-DC-Netzen. Ein schneller und sicherer DC-Schalter ermöglicht dort eine sichere Trennung von DC-Zonen, beispielsweise bei Flutung oder anderen Abschaltszenarien. Generell gilt dies auch im Betrieb von anderen Inselnetzen, bei denen verschiedene Zonen sicher und schnell trennbar bleiben müssen.

Vorteilhafte Ausgestaltungen der erfindungsgemäßen Schaltvorrichtung gehen aus den abhängigen Ansprüchen hervor. Dabei kann die Ausführungsform nach den unabhängigen Ansprüchen mit den Merkmalen eines der Unteransprüche oder vorzugsweise auch mit denen aus mehreren Unteransprüchen kombiniert werden. Demgemäß können noch zusätzlich folgende Merkmale vorgesehen sein:

- Zweckmäßig werden alle Schaltmodule mit einem Tastgrad betrieben. Da der Tastgrad abhängig von der Istspannung über das Halbleiterschaltelement ist, die der Spannung über die Serie aus Widerstand und Kondensator im selben Schaltmodul entspricht, hat jedes Schaltmodul seinen eigenen zeitlich veränderlichen Tastgrad. Dieser wird zu den meisten Zeitpunkten verschieden von denen der anderen Schaltmodule sein. Mit anderen Worten schalten alle Halbleiterschalterelemente der Schaltmodule mit einer vorgegebenen Frequenz, die zweckmäßig für alle Schaltmodule gleich gewählt wird. Die Zeitdauer innerhalb einer Schaltperiode, für ein Halbleiterschalterelement eingeschaltet ist, wird aber für jedes Schaltmodul separat ermittelt.

- Zweckmäßig umfasst die Schaltvorrichtung eine Steuervorrichtung zur Ansteuerung der Halbleiterschalterelemente der Schaltmodule. Die Steuervorrichtung ist ausgestaltet, eine Istspannung für jedes der Schaltmodule zu ermitteln. Die Sollspannung ist zweckmäßig in der Steuervorrichtung gespeichert oder kann in einer alternativen Ausgestaltung auch durch Messung ermittelt werden. Die Steuervorrichtung steuert die Schaltzeitpunkte der Halbleiterschalterelemente.

- Pro Schaltmodul können mehrere in Serie geschaltete Halbleiterschaltelemente vorhanden sein.

- Zweckmäßig ist der Tastgrad direkt proportional zu der Differenz aus der Istspannung und der Sollspannung. Es ist weiterhin zweckmäßig, als Sollspannung die Systemspannung des Gleichspannungsnetzes geteilt durch die Anzahl der Schaltmodule zu wählen. Damit strebt die Regelung direkt den Endzustand nach der Abschaltung an, in dem die Systemspannung des Gleichspannungsnetzwerks gleichmäßig auf die Schaltmodule verteilt ist.

- Es ist vorteilhaft, wenn der Tastgrad direkt proportional zu der Differenz aus einer maximalen Spannung für das steuerbare Halbleiterschaltelement, also der Sperrfähigkeit, und der Sollspannung ist. Damit wird eine Anpassung an die Stromtrag- und Sperrfähigkeit der Halbleiterschaltelemente, also die Auslegung der Schaltvorrichtung ermöglicht.

- Es ist vorteilhaft, wenn der Tastgrad auf einen oberen Grenzwert begrenzt wird, der so gewählt ist, dass die Spannung über die Schaltvorrichtung bei einem Abschaltvorgang nicht geringer als die Systemspannung des Gleichspannungsnetzes wird. Damit wird verhindert, dass in dem sehr dynamischen Abschaltvorgang die Regelung eine Situation erzeugt, bei der ein abzuschaltender Strom, also möglicherweise sogar ein Kurzschlussstrom, wieder ansteigt. Der obere Grenzwert kann dabei festgelegt und gespeichert sein oder aber dynamisch ermittelt werden.

- Die Ansteuerung der Halbleiterschaltelemente umfasst zweckmäßig einen Proportionalregler, wobei der Proportionalregler als Regeleingänge wenigstens den Istwert und den Sollwert der Spannung erhält.

- Es ist vorteilhaft, wenn die Schaltfrequenz des steuerbaren Halbleiterschaltelements wenigstens 5kHz, insbesondere wenigstens 20 kHz beträgt. Je höher die Schaltfrequenz ist, desto geringer sind die Schwankungen der Ladung der Kondensatoren, die sich durch Abfluss und Zufluss während einer Schaltperiode ergeben. Mit anderen Worten ist der Stromrippel geringer. Dadurch können die verwendeten Kondensatoren bei hoher Schaltfrequenz eine kleinere Kapazität aufweisen, was auch eine kleinere Baugröße zur Folge hat. Da die Kondensatoren typischerweise einen erheblichen Anteil zur gesamten Baugröße beitragen, kann dieser Vorteil erheblich sein.

- Werden als steuerbare Halbleiterschaltelemente sog. Wide Bandgap-Schalter, insbesondere SiC-Schalter oder GaN-Schalter, verwendet und eine Schaltfrequenz von wenigstens 50 kHz, insbesondere wenigstens 200 kHz verwendet, kann eine weitere Verringerung der Baugröße der Kondensatoren erreicht werden.

- Eine weitere zweckmäßige Ausgestaltung sieht vor, dass im Betrieb der Schaltvorrichtung zum Auftrennen des Strompfads bis zum Abbau der in den Induktivitäten gespeicherten Energie die Halbleiterschaltelemente unterschiedlicher Schaltmodule zu unterschiedlichen Zeitpunkten ein- und ausgeschaltet werden. Mit anderen Worten werden die Schaltmodule versetzt zueinander getaktet. Dadurch wird ein gleichzeitiges An- oder Abschalten der Schaltmodule sowie ein Überlappen der Einschaltdauern vermieden oder verringert und die Spannungsschwankungen über die Schaltvorrichtung minimiert.

- Eine weitere zweckmäßige Ausgestaltung sieht vor, dass in dem Pfad des steuerbaren Halbleiterschaltelements eines jeweiligen Schaltmoduls ein weiteres steuerbares Halbleiterschaltelement anti-seriell zu dem steuerbaren Halbleiterschaltelement verschaltet ist. Dadurch wird ein bidirektional betreibbares Schaltmodul bereitgestellt, so dass im Ergebnis die Schaltvorrichtung den Strompfad, unabhängig von der vorherrschenden Stromrichtung, abschalten kann.

Eine zweckmäßige Ausgestaltung gemäß einer ersten Variante sieht vor, dass die Parallelschaltung aus dem zumindest einen steuerbaren Schaltelement und der Serienschaltung aus dem Widerstand und dem Kondensator zwischen einem ersten Schaltmodulanschluss und einem zweiten Schaltmodulanschluss des jeweiligen Schaltmoduls verschaltet ist. Eine Mehrzahl an seriell verschalteten Schaltmodulen kann dann derart verschaltet werden, dass ein erster Schaltmodulanschluss eines Schaltmoduls mit dem zweiten Schaltmodulanschluss eines vorhergehenden Schaltmoduls verschaltet ist. Der erste Schaltmodulanschluss eines ersten Schaltmoduls ist über eine quellseitige Induktivität mit einer Gleichspannungsquelle, ein zweiter Schaltmodulanschluss eines letzten Schaltmoduls der Mehrzahl an Schaltmodulen über eine lastseitige Induktivität mit einer Last verschaltet. Ein derartiges Schaltmodul, bei dem zumindest ein steuerbares Halbleiterschaltelement, ein Widerstand und ein Kondensator vorgesehen sind, kommt mit einer minimalen Anzahl an Bauelementen aus.

Eine weitere zweckmäßige Ausgestaltung gemäß einer zweiten Variante sieht vor, dass die Parallelschaltung aus genau einem steuerbaren Halbleiterschaltelement und der Serienschaltung aus dem Widerstand und dem Kondensator (sog. Grundmodul) zwischen einem ersten Gleichrichtanschluss und einem zweiten Gleichrichtanschluss einer Gleichrichterbrücke des jeweiligen Schaltmoduls verschaltet ist. Der erste Gleichrichtanschluss ist ein erster Knotenpunkt der Gleichrichterbrücke, an den Kathodenanschlüsse zweier Gleichrichtelemente miteinander verschaltet sind. Der zweite Gleichrichtanschluss ist ein zweiter Knotenpunkt der Gleichrichterbrücke, an dem Anodenanschlüsse zweier weiterer Gleichrichtelemente miteinander verschaltet sind. Wird ein unidirektionales Grundmodul, d.h. ein Schaltmodul, dass lediglich ein einziges Halbleiterschaltelement umfasst, in der Gleichrichterbrücke vorgesehen, so kann das Schaltmodul für beide Stromrichtungen genutzt werden. Eine Stromumkehr wird durch die Gleichrichterbrücke, welche im einfachsten Fall eine Diodenbrücke ist, realisiert.

Gemäß dieser Ausgestaltung kann eine beliebige Anzahl an Schaltmodulen in Reihe verschaltet werden. Die Reihenschaltung erfolgt dabei derart, dass ein dritter Gleichrichtanschluss eines Schaltmoduls mit einem vierten Gleichrichtanschluss eines vorhergehenden Schaltmoduls verschaltet wird. Der dritte Gleichrichtanschluss ist ein dritter Knotenpunkt der Gleichrichterbrücke, an dem ein Kathodenanschluss eines Gleichrichtelements mit einem Anodenanschluss eines anderen Gleichrichtelements miteinander verschaltet ist. In entsprechender Weise ist der vierte Gleichrichtanschluss ein vierter Knotenpunkt der Gleichrichterbrücke, an dem ein Kathodenanschluss eines Gleichrichtelements mit einem Kathodenanschluss eines anderen Gleichrichtelements miteinander verschaltet ist.

Eine weitere zweckmäßige Ausgestaltung sieht vor, dass im Betrieb der Schaltvorrichtung zum Auftrennen des Strompfads bis zum Abbau der in den quell- und lastseitigen Induktivitäten gespeicherten Energie zu einem gegebenen Zeitpunkt das steuerbare Halbleiterschaltelement zumindest eines Schaltmoduls sperrend geschaltet ist. Somit kann verhindert werden, dass z.B. bei einem Auftrennvorgang aufgrund eines lastseitigen Kurzschlusses sich der Kurzschlussstrom wieder über die Schaltvorrichtung aufbauen kann.

Das steuerbare Halbleiterschaltelement ist zweckmäßig ein abschaltbares Halbleiterschaltelement. Neben den erwähnten GaN oder SiC-Schaltern können auch IGBTs, MOSFETs, IGCTs oder Thyristoren mit einer Abschalteinrichtung (sog. Löschkreis) eingesetzt werden. Die Sperrfähigkeit des steuerbaren Halbleiterschaltelements beträgt vorteilhaft wenigstens 400 V, insbesondere wenigstens 1 kV.

Die beschriebene Schaltvorrichtung ist insbesondere für die Verwendung in einem Gleichspannungsnetz mit einer Spannung von mehr als 400V, insbesondere mehr als 1000 V vorgesehen. Insbesondere lässt sich die Schaltvorrichtung in Hochspannungsgleichstromübertragungsleitungen einsetzen. In Abhängigkeit der in dem Gleichspannungsnetz vorherrschenden Spannung muss dann eine geeignete entsprechende Anzahl an Schaltmodulen der Schaltvorrichtung gewählt werden. Je höher die zu beherrschende Spannung in dem Gleichspannungsnetz ist, desto größer wird - gleiche Halbleiterschaltelemente vorausgesetzt - die Anzahl der Schaltmodule gewählt. Bei Gleichspannungsnetzen im Mittelspannungsbereich können insbesondere IGBTs oder MOSFETs zum Einsatz kommen. Bei noch höheren Spannungen kommen insbesondere Thyristoren mit einer Abschalteinrichtung oder IGCTs zum Einsatz. Eine weitere Ausgestaltung sieht vor, dass die Schaltvorrichtung der hier beschriebenen Art als Kurzschlussfester Leistungsschalter verwendet wird.

Die Erfindung wird nachfolgend näher anhand von Ausführungsbeispielen in der Zeichnung erläutert. Es zeigen:

Fig. 1 ein elektrisches Ersatzschaltbild, das den Aufbau eines einzelnen unidirektionalen Schaltmoduls für eine erfindungsgemäße Schaltvorrichtung zeigt;

Fig. 2 ein elektrisches Ersatzschaltbild einer seriellen Verschaltung von drei in Fig. 1 gezeigten Schaltmodulen;

Fig. 3    ein elektrisches Ersatzschaltbild einer erfindungsgemäßen Schaltvorrichtung in einem Gleichspannungsnetz mit quell- und lastseitigen Induktivitäten;

Fig. 4    ein Diagramm, das den zeitlichen Verlauf von Spannung und Strom bei einem Auftrennvorgang der erfindungsgemäßen Schaltvorrichtung mit acht Schaltmodulen zeigt;

Fig. 5    ein Diagramm, das den zeitlichen Verlauf der über acht seriell miteinander verschaltete Schaltmodule anfallenden Spannung zeigt;

Fig. 6    ein Ausführungsbeispiel eines erfindungsgemäßen bidirektionalen Schaltmoduls; und

Fig. 7    ein elektrisches Ersatzschaltbild einer erfindungsgemäßen Schaltvorrichtung in einem Gleichspannungsnetz, bei dem die Schaltvorrichtung aus zwei abgewandelten Schaltmodulen mit einem Brückengleichrichter besteht.

In der nachfolgenden Beschreibung sind gleiche Elemente mit gleichen Bezugszeichen versehen.

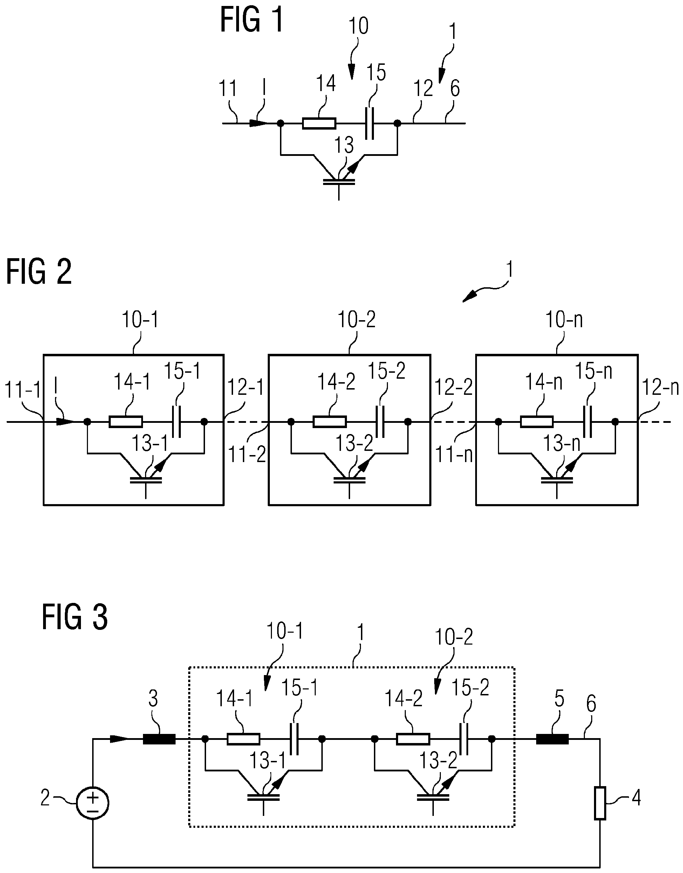

Fig. 1 zeigt den schematischen Aufbau eines Schaltmoduls 10 einer erfindungsgemäßen Schaltvorrichtung 1 zum Auftrennen eines quell- und lastseitige Induktivitäten umfassenden Strompfads 6. Das Schaltmodul 10 umfasst ein steuerbares Halbleiterschaltelement 13. Das steuerbare Halbleiterschaltelement 13 kann ein IGBT oder ein anderer Typ von abschaltbarem Halbleiterschalter sein. Die Lastanschlüsse des steuerbaren Halbleiterschaltelements 13 sind zwischen einem ersten Schaltmodulanschluss 11 und einem zweiten Schaltmodulanschluss 12 verschaltet. Zwischen dem ersten und dem zweiten Schaltmodulanschluss 11, 12 ist ferner eine Reihenschaltung aus einem Widerstand 14 und einem Kondensator 15 angeordnet. Mit anderen Worten ist ein aus dem Widerstand 14 und dem Kondensator 15 gebildetes RC-Glied parallel zu den Lastanschlüssen des steuerbaren Schaltelements 13 geschaltet.

Die prinzipielle Funktionsweise eines solchen einzelnen Schaltmoduls der erfindungsgemäßen Schaltvorrichtung 1 ist wie folgt: Soll die Schaltvorrichtung 1 Strom führen, so ist das steuerbare Halbleiterschaltelement 13 leitend geschaltet. Sobald der Strompfad 6 mit Hilfe der Schaltvorrichtung 1 aufgetrennt werden soll, wird das steuerbare Halbleiterschaltelement 13 durch eine in den Figuren nicht gezeigte Steuervorrichtung sperrend geschaltet. Dadurch kann der in dem Strompfad 6 fließende Strom I nur noch über das aus dem Widerstand 14 und dem Kondensator 15 gebildete RC-Glied weiter fließen. Der Kondensator 15 lädt sich infolge des in ihn fließenden Stroms I auf.

In der Folge wird das steuerbare Halbleiterschaltelement 13 durch die Steuervorrichtung mit einem Tastgrad betrieben, das heißt in regelmäßiger Folge leitend geschaltet und wieder sperrend geschaltet. Dafür wird eine festgelegte Schaltfrequenz verwendet wie beispielsweise 10 kHz. Daraus ergibt sich eine Periodendauer von 100 $\mu$s. Innerhalb dieser Periodendauer wird das steuerbare Halbleiterschaltelement 13 einmal eingeschaltet, also leitend geschaltet und einmal wieder abgeschaltet, also sperrend geschaltet. Der Tastgrad legt fest, für welchen Anteil der Periodendauer das steuerbare Halbleiterschaltelement 13 leitend geschaltet bleibt. Ein Tastgrad von 0 steht für eine völlige Sperrend-Schaltung, während ein Tastgrad von 30% bedeutet, dass das steuerbare Halbleiterschaltelement 13 innerhalb jeder Periodendauer von 100 $\mu$s für 30 $\mu$s leitend geschaltet ist. Es ist vorteilhaft, wenn als Schaltfrequenz eine möglichst hohe Frequenz wie beispielsweise 25 kHz verwendet wird. Durch die sich ergebende möglichst kurze Periodendauer und den damit verbundenen schnelleren Wechsel von leitendem und sperrendem Zustand wird die sich ergebende Auf- und Entladung, also der Spannungs-Rippel geringer und die Kondensatoren können für geringere Spannungen ausgelegt werden. Dadurch kann Bauraum für die Schaltung eingespart werden.

Um den aktuellen Tastgrad für eines der Schaltmodule 10 festzulegen, wird zuerst die Istspannung über das Schaltmodul 10 ermittelt. Diese Istspannung kann gemessen oder rechnerisch ermittelt werden. Zweckmäßig ist eine Messung des Stroms, die beispielsweise zur Kurzschlussdetektion ohnehin erfolgen muss. Aus dem Strom und dem Tastgrad jedes Schaltmoduls, d.h. der Einschaltdauer, kann die Spannung des Schaltmoduls errechnet werden. Diese Spannung versucht der Regler nun auf die Systemspannung geteilt durch die Anzahl der in Reihe geschalteten Schalter zu regeln. Dafür können verschiedene Regleransätze verwendet werden.

Eine beispielhafte Möglichkeit ist ein Proportionalregler (P-Regler). Auch ein proportional integrierender Regler (PI-Regler) kann verwendet werden. Der Tastgrad (Aussteuergrad) jedes der Schaltermodule 10 setzt sich folgendermaßen zusammen:

$$a_i = \left( U_i - \frac{U_S}{N} \right) \cdot k_p$$

Der Tastgrad (0 bis 100%) entspricht also der gemessenen oder berechneten Schalterspannung $U_i$ für das i-te Halbleiterschaltelement 13 im i-ten Schaltmodul 10 minus die Systemspannung $U_s$ geteilt durch die Anzahl der Schaltmodule N, multipliziert mit der Reglerkonstante $k_p$. Der Term $U_s / N$ kann als Sollspannung über jedes der Schaltmodule 10 im abgeschalteten Zustand angesehen werden. Dabei lässt sich die Reglerkonstante $k_p$ folgendermaßen berechnen:

$$k_p = \left(U_{max} - \frac{U_S}{N}\right) \cdot a_{max}$$

Dabei entspricht $U_{max}$ der Schalterspannung, die maximal über ein Halbleiterschaltelement 13 auftreten darf und $a_{max}$ dem maximalen Aussteuergrad, für den das System ausgelegt ist. Dabei stellt der maximale Aussteuergrad einen Auslegungsparameter für das Halbleiterschaltelement 13 dar. Je größer dieser Wert ist, für desto größere Ströme und kleinere Spannungen ist das System ausgelegt; je kleiner der Wert, für desto grö-ßere Spannungen und kleinere Ströme.

Bei dieser Art der Regelung stellt der Kurzschlussstrom eine Störgröße dar. Auch die aus den Kondensatoren abfließende Energie, wenn der Schalter geschlossen ist, ist in dieser Regelung nicht betrachtet und stellt eine Störgröße dar. Bei dieser Auslegung kann es passieren, dass der Aussteuergrad zu groß gewählt wird, sodass die über dem gesamten Schalter aufgebaute Spannung im Mittel kleiner als die Systemspannung wird und der Strom weiter ansteigen würde. Dies sollte aber verhindert werden. Aus diesem Grund ist es zweckmäßig, nach dem Proportionalregler noch ein Begrenzungsglied folgen zu lassen. Dieses begrenzt den maximalen Aussteuergrad derart, dass die über dem gesamten Schalter abfallende Spannung im zeitlichen Mittel nicht kleiner als die Systemspannung wird. Kurzfristige Unterschreitungen der Systemspannung sind hingegen möglich und in den Figuren 4 bis 7 zu erkennen.

Fig. 2 zeigt ein elektrisches Ersatzschaltbild einer seriellen Verschaltung von n Schaltmodulen 10-1, 10-2, ..., 10-n (allgemein: 10-i, wobei i = 1 bis n). Jedes der Schaltmodule 10-i ist in der wie in Fig. 1 beschriebenen Weise aufgebaut. Die serielle Verschaltung der Schaltmodule 10-i erfolgt dabei derart, dass der zweite Schaltmodulanschluss 12-1 des ersten Schaltmoduls 10-1 mit dem ersten Schaltmodulanschluss 11-2 des nachfolgenden Schaltmoduls 10-2 verbunden ist, und so weiter. Der erste Schaltmodulanschluss 11-1 des ersten Schaltmoduls 10-1 ist, wie in Fig. 3 gezeigt, über eine quellseitige Induktivität 3 mit einer Gleichspannungsquelle 2 verbunden. Bei der Gleichspannungsquelle 2 kann es sich beispielsweise um eine Energieerzeugungseinheit, z.B. eine Photovoltaikanlage, ein Speichersystem, ein Batterieladegerät, eine Windenergieanlage, einen Gleichrichter und dergleichen handeln. Der zweite Schaltmodulanschluss 12-n des letzten Schaltmoduls 10-n ist, wie in Fig. 3 gezeigt, über eine lastseitige Induktivität 6 mit einer Last 4 verschaltet. Bei der Last 4 kann es sich beispielsweise um einen Antrieb eines Gleichspannungsnetzes o.ä. handeln.

Fig. 3 zeigt das elektrische Ersatzschaltbild einer erfindungsgemäßen Schaltvorrichtung 1, welche aus zwei seriell miteinander verschalteten Schaltmodulen 10-1 und 10-2 besteht, welche jeweils wie in Fig. 1 beschrieben aufgebaut sind. Die Schaltvorrichtung 1 ist über die bereits erwähnte quellseitige Induktivität 3 mit der Gleichspannungsquelle 2 verbunden. Ausgangsseitig ist die Schaltvorrichtung 1 über die lastseitige Induktivität 5 mit der Last 4 verbunden. Die quell- und lastseitigen Induktivitäten 3, 5 müssen nicht zwingend physikalische Komponenten des Gleichspannungsnetzes darstellen. Die quell- und lastseitigen Induktivitäten 3, 5 können auch Leitungsinduktivitäten sein.

Die Funktionsweise der in Fig. 3 gezeigten Schaltvorrichtung ist wie folgt: Wenn die Last 4 aus der Gleichspannungsquelle 2 mit Strom versorgt werden soll, sind die steuerbaren Halbleiterschaltelemente 13-1, 13-2 (allgemein: 13-i, i = 1 bis 2) der Schaltmodule 10-1, 10-2 (allgemein: 10-i, i = 1 bis 2) leitend geschaltet. Sobald der Strompfad 6, z.B. aufgrund eines lastseitigen Kurzschlusses aufgetrennt werden soll, wird in einen Betrieb mit Tastgrad gewechselt, in dem die steuerbaren Halbleiterschaltelemente 13-i wie bereits beschrieben mit einer festen Frequenz zwischen leitendem und sperrendem Zustand wechseln. Dabei werden die steuerbaren Halbleiterschaltelemente 13-i zweckmäßig versetzt angesteuert, sodass ihre Einschaltzeiten möglichst wenig überlappen. Durch die Regelung des Tastgrads in Abhängigkeit von der jeweiligen Schalterspannung und der Sollspannung wird sichergestellt, dass über beiden steuerbaren Halbleiterschaltelementen 13-i zusammen eine Summenspannung $U_{ges}$ liegt, mit der der Stromfluss und damit die in den Induktivitäten 3, 5 gespeicherte Energie abgebaut wird.

Anders als bei der Verwendung eines einzigen Schaltmoduls liegt bei einer Mehrzahl von Schaltmodulen immer eine Gegenspannung (d.h. eine entgegen der Spannungsrichtung der Gleichspannungsquelle 2 gerichtete Spannung) im Gleichspannungsnetz an. Wenn die Anzahl n der in Serie verschalteten Schaltmodule sehr groß ist, fällt das kurzzeitige Kurzschlie-ßen eines Schaltmoduls kaum ins Gewicht, wodurch sich der Strom allmählich abbaut. Das beschriebene Vorgehen wird unabhängig davon, wie groß die Anzahl n der in Reihe verschalteten Schaltmodule ist, in entsprechender Weise durchgeführt.

Fig. 4 zeigt den zeitlichen Verlauf der Spannung 42 und des Stroms 41 für eine Schaltvorrichtung 1, die acht Schaltmodule 10 umfasst. In dem Diagramm der Fig. 4 wird von einer Nennspannung von 6 kV und einem Strom von 2 kA ausgegangen. Die quellseitige Induktivität beträgt im gezeigten Ausführungsbeispiel 1 mH, während für diese Simulation keine lastseitige Induktivität verwendet wurde. In realen Umgebungen werden typischerweise beiderseits Induktivitäten vorliegen, wobei diese durch diskrete Bauteile gebildet werden oder parasitär vorliegen können oder beides zusammen. Es ist gut zu erkennen, dass zu einem Zeitpunkt bei $t \approx 0{,}6$ ms die Auftrennung des Strompfads erfolgt. Die Spannung 42, die über der Schaltvorrichtung 1 vor dem Abschalten abfällt, wird durch die Durchlassverluste des steuerbaren Halbleiterschaltelements 13 bestimmt. Durch das Abschalten zum Zeitpunkt $t \approx 0{,}6$ ms steigt die Spannung auf etwas unter 10 kV an. Durch das getaktete Aus- und Einschalten des steuerbaren Halbleiterschaltelements ergibt sich bis zum Zeitpunkt t ≈ 4 ms ein zwischen 4 kV und 12 kV bleibender Verlauf, wobei der Strom I durch die Gegenspannung innerhalb von etwa 2,5 ms abgebaut wird.

Fig. 5 zeigt ein Diagramm, in dem der zeitliche Verlauf der Spannungen bei einem Abschaltvorgang der Schaltvorrichtung 1 mit acht in Serie verschalteten Schaltmodulen in höherer zeitlicher Auflösung gezeigt ist. Dabei schalten in der Simulation, die dem Diagramm der Fig. 5 zugrunde liegt, jeweils zwei der acht Schaltmodule zum selben Zeitpunkt, sodass nur vier separate Spannungsverläufe 51...54 - für vier Paare aus Schaltmodulen 10 - erkennbar sind. Durch den gezeigten Zeitausschnitt zwischen 1,5 ms und 4,5 ms wird gut das Takten der steuerbaren Halbleiterschaltelemente der Schaltmodule 10 mit einer festen Schaltfrequenz von 5 kHz ersichtlich. Weiterhin ist ersichtlich, dass die vier Paare von Schaltmodulen phasenversetzt zueinander schalten und zu einem gegebenen Zeitpunkt zumindest ein steuerbares Halbleiterschaltelement 13-i sperrend geschaltet ist. Anfänglich, also bei hohem Tastgrad überlappen die Einschaltzeiträume dabei dennoch aufgrund ihrer jeweiligen Länge, also aufgrund des noch hohen Tastgrads. Ab etwa 2 ms beginnen die Einschaltzeiträume nicht mehr zu überlappen. Ab etwa 3 ms ist erkennbar, dass die Tastgrade klein werden und die Halbleiterschaltelemente 13-i nur noch für kurze Zeiträume eingeschaltet werden, allerdings immer noch mit derselben Frequenz.

In dem Diagramm der Figur 5 arbeiten zwei der vier Paare von Schaltmodulen 10 mit einer geringeren Spannung 53, 54 als die anderen zwei Paare. Dies ist ein Artefakt der Simulation. Eine solche Ansteuerung ist prinzipiell möglich. Zweckmäßig und vorteilhaft für den gesamten Schalter ist es jedoch, wenn alle Schaltmodule 10 in der gleichen Weise betrieben werden, also auch mit gleicher Spannungsbelastung arbeiten. Durch die unterschiedlichen Spannungsniveaus 51...54 der Schaltmodule 10 in Figur 5 kommt es auch zu verschiedenen Tastgraden, was im Bereich von t = 3 ms erkennbar ist. Weiterhin schalten die Schaltmodule 10 mit der geringeren Spannung auch etwas früher gänzlich ab, bei etwa t = 3,5 ms. Das gänzliche Abschalten eines Schaltmoduls 10 wird bewirkt, wenn der Strom unter einen festlegbaren Schwellwert wie beispielsweise 50 A sinkt und die Spannung über das Schaltmodul 10, also die Spannung des Kondensators 15-i nahe an der Systemspannung ist, also die Differenz zur Systemspannung einen Schwellwert unterschreitet.

Durch die beschriebene Regelung des Tastgrads in Abhängigkeit von der Differenz von Istspannung und Sollspannung für jedes der Schaltmodule 10-i hängt der Tastgrad wesentlich von der aktuell vorliegenden induktiv bewirkten Überspannung über die gesamte Schaltvorrichtung ab. Nähert sich diese 0 V, wie in Figur 4 und Figur 5 ab einer Zeit von etwa 2,5 ms, sinkt der Tastgrad entsprechend ab. Da aber stets noch eine kurze Einschaltzeit vorliegt, wird den Kondensatoren 15-i stets noch ein Entladen ermöglicht. Daher liegt beim Ausbleiben der Überspannung, d.h. nach Abbau der Energie auch keine wesentliche Überspannung der Kondensatoren 15-i mehr vor, die einen Stromrückfluss und damit ein Nachpendeln des Stroms bewirken würde. Nachfolgende Schwingungen werden wie in Figur 4 deutlich zu erkennen fast völlig vermieden. Ein dennoch vorliegender vergleichsweise schwacher und kurz andauernder Rückstrom ist in Figur 5 ab etwa t = 3 ms daran zu erkennen, dass die Spannung über die Kondensatoren 15-i bei sperrend geschaltetem Halbleiterschaltelement 13-i absinkt, anstatt anzusteigen. Ab diesem Zeitpunkt erreicht der Strom erstmalig 0 A, während die gesamte Spannung über die Schaltvorrichtung noch etwas höher als die Nennspannung von 6 kV ist.

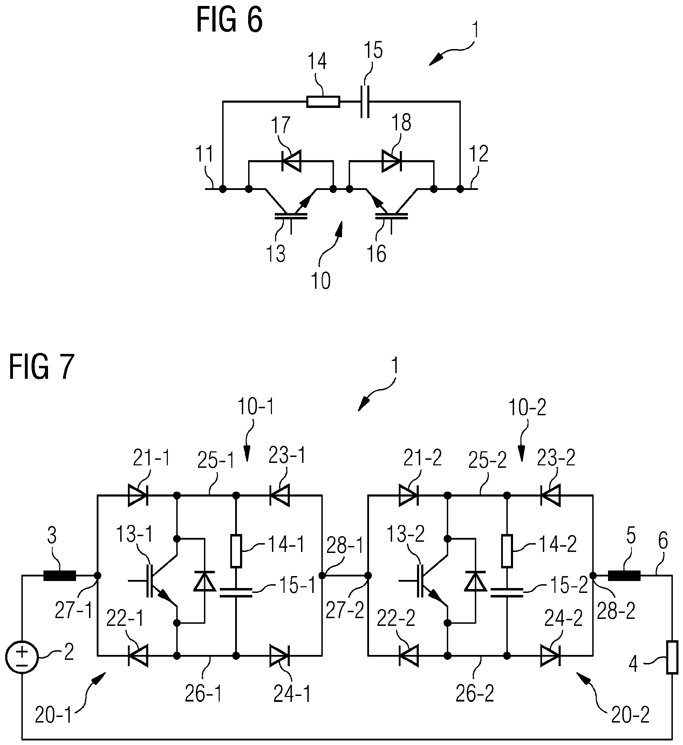

Fig. 6 zeigt eine Abwandlung des in Fig. 1 gezeigten Schaltmoduls 10. Zusätzlich zu dem Halbleiterschaltelement 13 ist ein weiteres Halbleiterschaltelement 16 anti-seriell zu dem steuerbaren Halbleiterschaltelement 13 verschaltet. Das steuerbare Halbleiterschaltelement 13 und das weitere steuerbare Halbleiterschaltelement 16 können vom gleichen Typ sein, z.B. IGBTs. Das Verhalten dieses bidirektional betreibbaren Schaltmoduls 10 entspricht dem Verhalten des Schaltmoduls aus Fig. 1. Der Stromfluss kann bei dem in Fig. 6 gezeigten bidirektionalen Schaltmodul 10 in beide Richtungen gerichtet sein. Dabei ist eines der beiden steuerbaren Halbleiterschaltelemente 13, 16 im leitenden Fall leitend und das andere sperrend geschaltet. Der Stromfluss wird über eine jeweilige anti-parallel geschaltete Diode 17 bzw. 18 gewährleistet.

Fig. 7 zeigt ein weiteres elektrisches Ersatzschaltbild einer erfindungsgemäßen Schaltvorrichtung 1, wobei diese exemplarisch zwei Schaltvorrichtungen 10-1 und 10-2 umfasst. Diese sind wie in Fig. 3 zwischen einer quellseitigen Induktivität 3 und einer lastseitigen Induktivität 5 verschaltet. Die Schaltmodule 10-1 und 10-2 (allgemein: 10-i, wobei i = 1 bis 2) sind in der Lage einen bidirektionalen Stromfluss zu verarbeiten. Hierzu ist ein wie in Fig. 1 gezeigtes Grundmodul in eine Gleichrichterbrücke 20-1 und 20-2 (allgemein: 20-i, wobei i = 1 bis 2) integriert. Der Aufbau wird anhand des Schaltmoduls 10-1 beschrieben, wobei der Aufbau des Schaltmoduls 10-2 identisch ist.

Die Gleichrichterbrücke 20-1 ist als Diodenbrücke mit vier Dioden 21-1, 22-1, 23-1 und 24-1 realisiert. Ein erster Gleichrichteranschluss 25-1 ist zwischen Kathoden der Dioden 21-1 und 23-1 gebildet. Ein zweiter Gleichrichteranschluss 26-1 ist zwischen Anodenanschlüssen der Dioden 22-1 und 24-1 gebildet. Das wie in Fig. 1 aufgebaute Schaltmodul ist zwischen dem ersten Gleichrichteranschluss 25-1 und dem zweiten Gleichrichteranschluss 26-1 verschaltet. Ein dritter Gleichrichteranschluss 27-1 ist zwischen der Anode der Diode 21-1 und der Kathode der Diode 22-1 ausgebildet. Der dritte Gleichrichteranschluss 27-1 ist über die quellseitige Induktivität 3 mit der Gleichspannungsquelle 2 verbunden. Ein vierter Gleichrichteranschluss 28-1 ist zwischen einer Anode der Diode 23-1 und einer Kathode der Diode 24-1 ausgebildet. Der vierte Gleichrichteranschluss 28-1 ist mit dem ersten Gleichrichteranschluss 27-2 des zweiten Schaltmoduls 10-2 verschaltet.

In der Gleichrichterbrücke 20-1 ist somit ein unidirektionales Grundmodul angeordnet, welche zusammen das Schaltmodul 10-1 ergeben. Dieses wird für beide Stromrichtungen genutzt, wobei die Stromumkehr durch die Elemente der Gleichrichterbrücke 20-i realisiert wird. Der Einfachheit halber sind Fig. 7 lediglich die Gleichspannungsquelle 2 links und die Last 4 rechts von der Schaltvorrichtung 1 dargestellt. Für einen bidirektionalen Betrieb weist die Anordnung eine weitere Gleichspannungsquelle rechts und eine weitere Last 4 links von der Schaltvorrichtung 1 auf.

Wie in Fig. 7 gezeigt, können von den Schaltmodulen 10-i eine beliebige Anzahl in Reihe geschaltet werden.

Bezugszeichenliste

| | |
|---|---|
| 1 | Schaltvorrichtung |
| 2 | Gleichspannungsquelle |
| 3 | quellseitige Induktivität |
| 4 | Last |
| 5 | lastseitige Induktivität |
| 6 | Strompfad |
| 10,10-i | Schaltmodul |
| 11,11-i | Schaltmodulanschluss |
| 12,12-i | Schaltmodulanschluss |
| 13,13-i | steuerbares Halbleiterschaltelement |
| 14,14-i | Widerstand |
| 15,15-i | Kondensator |
| 16 | weiteres steuerbares Halbleiterschaltelement |
| 17 | Diode |
| 18 | Diode |
| 20-i | Gleichrichterbrücke |
| 21-i...24-i | Diode |
| 25-i | Gleichrichteranschluss |
| 26-i | Gleichrichteranschluss |
| 27-i,28-i | Gleichrichteranschluss |
| 41 | Schalter-Strom |
| 42 | Schalter-Spannung |
| 51...54 | Schaltmodulspannungen |

**Patentansprüche**

1. Schaltvorrichtung (1) zum Auftrennen eines quell- und/oder lastseitige Induktivitäten (3, 5) umfassenden Strompfads (6) eines Gleichspannungsnetzes, umfassend zumindest zwei in Serie verschaltete Schaltmodule (10), wobei jedes der Schaltmodule (10) zumindest ein steuerbares Halbleiterschaltelement (13, 16) umfasst, dem eine Serienschaltung aus einem Widerstand (14) und einem Kondensator (15) parallel geschaltet ist,

 wobei die Schaltvorrichtung so ausgestaltet ist, dass beim Auftrennen des Strompfads (6) zum Abbau der in den Induktivitäten (3, 5) gespeicherten Energie das Halbleiterschaltelement (13, 16) wenigstens eines der Schaltmodule (10) mit einem Tastgrad leitend geschaltet wird, **dadurch gekennzeichnet, dass** der Tastgrad unter Verwendung der Differenz zwischen der Istspannung über das Halbleiterschaltelement und einer Sollspannung über das Halbleiterschaltelement gebildet ist und wobei die Sollspannung wenigstens aus der Systemspannung des Gleichspannungsnetzes und der Anzahl der Schaltmodule (10) gebildet ist.

2. Schaltvorrichtung (1) nach Anspruch 1, bei der der Tastgrad direkt proportional zu der Differenz aus der Istspannung und der Sollspannung ist.

3. Schaltvorrichtung (1) nach einem der vorangehenden Ansprüche, bei der die Sollspannung gleich der Systemspannung des Gleichspannungsnetzes geteilt durch die Anzahl der Schaltmodule (10) ist.

4. Schaltvorrichtung (1) nach einem der vorangehenden Ansprüche, derart ausgestaltet, dass der Tastgrad auf einen oberen Grenzwert begrenzt wird, der so gewählt ist, dass die Spannung über die Schaltvorrichtung (1) bei einem Abschaltvorgang im zeitlichen Mittel nicht geringer als die Systemspannung des Gleichspannungsnetzes wird.

5. Schaltvorrichtung (1) nach einem der vorangehenden Ansprüche, mit jeweils einem Proportionalregler für die Ansteuerung der steuerbaren Halbleiterschaltelemente (13, 16), wobei der Proportionalregler als Regeleingänge wenigstens den Istwert und den Sollwert der Spannung erhält.

6. Schaltvorrichtung (1) nach einem der vorangehenden Ansprüche, derart ausgestaltet, dass die Schaltfrequenz des steuerbaren Halbleiterschaltelements (13, 16) wenigstens 5kHz, insbesondere wenigstens 20 kHz beträgt.

7. Schaltvorrichtung (1) nach einem der vorangehenden Ansprüche, wobei das steuerbare Halbleiterschaltelement (13, 16) ein Wide Bandgap-Schalter, insbesondere SiC-Schalter oder GaN-Schalter ist und die Schaltfrequenz wenigstens 50 kHz, insbesondere wenigstens 200 kHz beträgt.

8. Schaltvorrichtung (1) nach einem der vorangehenden Ansprüche, bei der die Parallelschaltung aus dem zumindest einen steuerbaren Halbleiterschaltelement (13, 16) und der Serienschaltung aus dem Widerstand (14) und dem Kondensator (15) zwischen einem ersten Gleichrichtanschluss (25) und einem zweiten Gleichrichtanschluss (26) einer Gleichrichterbrücke (20) des jeweiligen Schaltmoduls (10) verschaltet ist, wobei der erste Gleichrichtanschluss (25) ein erster Knotenpunkt der Gleichrichterbrücke (20) ist, an dem Kathodenanschlüsse zweier Gleichrichtelemente (21, 23) miteinander verschaltet sind, und wobei der zweite Gleichrichtanschluss (26) ein zweiter Knotenpunkt (26) der Gleichrichterbrücke (20) ist, an dem Anodenanschlüsse zweier weiterer Gleichrichtelemente (22, 24) miteinander verschaltet sind.

9. Schaltvorrichtung (1) nach einem der vorhergehenden Ansprüche, bei der im Betrieb der Schaltvorrichtung (1) zum Auftrennen des Strompfads (6) bis zum Abbau der in den Induktivitäten (3, 5) gespeicherten Energie zu einem gegebenen Zeitpunkt das steuerbare Halbleiterschaltelement (13, 16) einer ersten Teilanzahl von Schaltmodulen (10) sperrend geschaltet und eine zweite Teilanzahl von Schaltmodulen (10) leitend geschaltet ist.

10. Schaltvorrichtung (1) nach einem der vorhergehenden Ansprüche, bei der im Betrieb der Schaltvorrichtung (1) zum Auftrennen des Strompfads (6) bis zum Abbau der in den Induktivitäten (3, 5) gespeicherten Energie die Halbleiterschaltelemente (1, 16) unterschiedlicher Schaltmodule (10) zu unterschiedlichen Zeitpunkten ein- und ausgeschaltet werden.

11. Schaltvorrichtung (1) nach einem der vorhergehenden Ansprüche, bei der in dem Pfad des steuerbaren Halbleiterschaltelements (13) eines jeweiligen Schaltmoduls (10) ein weiteres steuerbares Halbleiterschaltelement (16) anti-seriell zu dem steuerbaren Halbleiterschaltelement (13) verschaltet ist.

12. Schaltvorrichtung (1) nach einem der vorhergehenden Ansprüche, bei der das steuerbare Halbleiterschaltelement (13, 16) eine Sperrfähigkeit von wenigstens 400 V, insbesondere wenigstens 1000 V aufweist.

13. Gleichspannungsnetzwerk mit einer Systemspannung von wenigstens 400 V, insbesondere wenigstens 1 kV mit einer Schaltvorrichtung (1) gemäß einem der vorangehenden Ansprüche.

14. Verwendung der Schaltvorrichtung (1) gemäß einem der Ansprüche 1 bis 12 als kurzschlussfester Leistungsschalter.

## Claims

1. Switching apparatus (1) for disconnecting a current path (6) of a DC voltage network, which current path comprises source-side and/or load-side inductances (3, 5), comprising at least two switching modules (10) connected in series, wherein each of the switching modules (10) comprises at least one controllable semiconductor switching element (13, 16) with which a series circuit comprising a resistor (14) and a capacitor (15) is connected in parallel,

   wherein the switching apparatus is configured in such a manner that, during disconnection of the current path (6), in order to reduce the energy stored in the inductances (3, 5), the semiconductor switching element (13, 16) of at least one of the switching modules (10) is turned on with a duty factor,
   **characterized in that** the duty factor is formed using the difference between the actual voltage across the semiconductor switching element and a setpoint voltage across the semiconductor switching element, and wherein the setpoint voltage is formed at least from the system voltage of the DC voltage network and the number of switching modules (10).

2. Switching apparatus (1) according to Claim 1, in which the duty factor is directly proportional to the difference between the actual voltage and the setpoint voltage.

3. Switching apparatus (1) according to one of the preceding claims, in which the setpoint voltage is equal to the system voltage of the DC voltage network divided by the number of switching modules (10).

4. Switching apparatus (1) according to one of the preceding claims, configured in such a manner that the duty factor is limited to an upper limit value which is selected in such a manner that the voltage across the switching apparatus (1) during a switching-off process does not become lower on temporal average than the system voltage of the DC voltage network.

5. Switching apparatus (1) according to one of the preceding claims, having in each case a proportional controller for controlling the controllable semiconductor switching elements (13, 16), wherein the proportional controller receives, as control inputs, at least the actual value and the setpoint value of the voltage.

6. Switching apparatus (1) according to one of the preceding claims, configured in such a manner that the switching frequency of the controllable semiconductor switching element (13, 16) is at least 5 kHz, in particular at least 20 kHz.

7. Switching apparatus (1) according to one of the preceding claims, wherein the controllable semiconductor switching element (13, 16) is a wide bandgap switch, in particular an SiC switch or a GaN switch, and the switching frequency is at least 50 kHz, in particular at least 200 kHz.

8. Switching apparatus (1) according to one of the preceding claims, in which the parallel circuit comprising the at least one controllable semiconductor switching element (13, 16) and the series circuit comprising the resistor (14) and the capacitor (15) is connected between a first rectifying connection (25) and a second rectifying connection (26) of a rectifier bridge (20) of the respective switching module (10), wherein the first rectifying connection (25) is a first node of the rectifier bridge (20), at which cathode connections of two rectifying elements (21, 23) are connected to one another, and wherein the second rectifying connection (26) is a second node (26) of the rectifier bridge (20), at which anode connections of two further rectifying elements (22, 24) are connected to one another.

9. Switching apparatus (1) according to one of the preceding claims, in which, during operation of the switching apparatus (1) for disconnecting the current path (6) until the energy stored in the inductances (3, 5) has been reduced, the controllable semiconductor switching element (13, 16) of a first portion of switching modules (10) is turned off at a given time and a second portion of switching modules (10) is turned on.

10. Switching apparatus (1) according to one of the preceding claims, in which, during operation of the switching apparatus (1) for disconnecting the current path (6) until the energy stored in the inductances (3, 5) has been reduced, the semiconductor switching elements (1, 16) of different switching modules (10) are switched on and off at different times.

11. Switching apparatus (1) according to one of the preceding claims, in which a further controllable semiconductor switching element (16) is reverse-connected in series with the controllable semiconductor switching element (13) in the path of the controllable semiconductor switching element (13) of a respective switching module (10).

12. Switching apparatus (1) according to one of the preceding claims, in which the controllable semiconductor switching element (13, 16) has a blocking capability of at least 400 V, in particular at least 1000 V.

13. DC voltage network having a system voltage of at least 400 V, in particular at least 1 kV, having a switching apparatus (1) according to one of the preceding claims.

14. Use of the switching apparatus (1) according to one of Claims 1 to 12 as a short-circuit-proof circuit breaker.

## Revendications

1. Montage (1) de coupure pour la séparation d'un chemin (6) de courant, comprenant des inductances (3, 5) du côté source et/ou du côté charge, d'un réseau de tension continue, comprenant au moins deux modules (10) de coupure montés en série, dans lequel chacun des modules (10) de coupure comprend au moins un élément (13, 16) de coupure à semiconducteur pouvant être commandé, en parallèle duquel est monté un circuit série composé d'une résistance (14) et d'un condensateur (15),

dans lequel le montage de coupure est conformé de manière à ce que, lors de la séparation du chemin (6) de courant pour la suppression de l'énergie emmagasinée dans les inductances (3, 5), l'élément (13, 16) de coupure à semiconducteur d'au moins l'un des modules (10) de coupure est monté conducteur avec un degré d'échantillonnage,
**caractérisé en ce que**
le degré d'échantillonnage est formé en utilisant la différence entre la tension réelle aux bornes de l'élément de coupure à semiconducteur et une tension de consigne aux bornes de l'élément de coupure à semiconducteur et dans lequel la tension de consigne est formée au moins à partir de la tension de système du réseau à tension continue et du nombre des modules (10) de coupure.

2. Montage (1) de coupure suivant la revendication 1, dans lequel le degré d'échantillonnage est directement proportionnel à la différence entre la tension réelle et la tension de consigne.

3. Montage (1) de coupure suivant l'une des revendications précédentes, dans lequel la tension de consigne est égale à la tension de système du réseau à tension continue divisée par le nombre des modules (10) de coupure.

4. Montage (1) de coupure suivant l'une des revendications précédentes, qui est conformé de manière à ce que le degré d'échantillonnage soit limité à une valeur limite supérieure, qui est choisie de manière à ce que la tension aux bornes du montage (1) de coupure ne soit pas, lors d'une opération de coupure, en moyenne dans le temps, plus basse que la tension de système du réseau à tension continue.

5. Montage (1) de coupure suivant l'une des revendications précédentes, comprenant respectivement un régleur proportionnel pour la commande des éléments (13, 16) de coupure à semiconducteur pouvant être commandés, dans lequel le régleur proportionnel reçoit, comme entrées de réglage, au moins la valeur réelle et la valeur de consigne de la tension.

6. Montage (1) de coupure suivant l'une des revendications précédentes, qui est conformé de manière à ce que la fréquence de coupure de l'élément (13, 16) de coupure à semiconducteur pouvant être commandé soit d'au moins 5 kHz, en particulier d'au moins 20 kHz.

7. Montage (1) de coupure suivant l'une des revendications précédentes, dans lequel l'élément (13, 16) de coupure à semiconducteur pouvant être commandé est un interrupteur wide bandgap, en particulier un interrupteur au SiC ou un interrupteur au GaN, et la fréquence de coupure est d'au moins 50 kHz, en particulier d'au moins 200 kHz.

8. Montage (1) de coupure suivant l'une des revendications précédentes, dans lequel le circuit parallèle, composé du au moins un élément (13, 16) de coupure à semiconducteur pouvant être commandé et du circuit série composé de la résistance (14) et du condensateur (15), est monté entre une première borne (25) de redresseur et une deuxième borne (26) de redresseur d'un pont (20) redresseur du module (10) de coupure respectif, dans lequel la première borne (25) de redresseur est un premier point nodal du pont (20) redresseur, où des bornes de cathode de deux éléments (21, 23) redresseurs sont connectées l'une à l'autre, et dans lequel la deuxième borne (26) de redresseur est un deuxième point (26) nodal du pont (20) redresseur, où des bornes d'anode de deux autres éléments (22, 24) redresseurs sont connectées l'une à l'autre.

9. Montage (1) de coupure suivant l'une des revendications précédentes, dans lequel, lorsque le montage (1) de coupure est en fonctionnement, pour la séparation du chemin (6) de courant jusqu'à la suppression de l'énergie emmagasinée dans les inductances (3, 5), à un instant donné, l'élément (13, 16) de coupure à semiconducteur pouvant être commandé d'un premier nombre partiel de modules (10) de coupure est monté bloquant et un deuxième nombre partiel de modules (10) de coupure est monté conducteur.

10. Montage (1) de coupure suivant l'une des revendications précédentes, dans lequel, lorsque le montage (1) de coupure est en fonctionnement, pour la séparation du chemin (6) de courant jusqu'à la suppression de l'énergie emmagasinée dans les inductances (3, 5), les éléments (1, 16) de coupure à semiconducteur de modules (10) de coupure différents sont fermés et ouverts à des instants différents.

11. Montage (1) de coupure suivant l'une des revendications précédentes, dans lequel, dans le chemin de l'élément (13) à semiconducteur pouvant être commandé d'un module (10) de coupure respectif, un autre élément (16) de coupure à semiconducteur pouvant être commandé est monté tête bêche avec l'élément (13) de coupure à semiconducteur pouvant être commandé.

12. Montage (1) de coupure suivant l'une des revendications précédentes, dans lequel l'élément (13, 16) de coupure à semiconducteur pouvant être commandé a une capacité de blocage d'au moins 400 V, en particulier d'au moins 1000 V

13. Réseau à tension continue ayant une tension de système d'au moins 400 V, en particulier d'au moins 1 kV, comprenant un montage (1) de coupure suivant l'une des revendications précédentes.

14. Utilisation du montage (1) de coupure suivant l'une des revendications 1 à 12 comme disjoncteur résistant au court-circuit.

FIG 1

FIG 2

FIG 3

## FIG 4

## FIG 5

## FIG 6

## FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3367567 A1